(19) Europäisches Patentamt
European Patent Office
Office européen des brevets

(11) **EP 3 089 346 A1**

(12) **EUROPEAN PATENT APPLICATION**
published in accordance with Art. 153(4) EPC

(43) Date of publication:
**02.11.2016 Bulletin 2016/44**

(51) Int Cl.:
*H02M 7/537* (2006.01)       *H02M 1/08* (2006.01)
*H02M 7/48* (2007.01)

(21) Application number: **13900448.5**

(22) Date of filing: **27.12.2013**

(86) International application number:
**PCT/JP2013/085030**

(87) International publication number:
**WO 2015/097836 (02.07.2015 Gazette 2015/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Hitachi Industrial Equipment Systems
Co., Ltd.**
**Chiyoda-ku**
**Tokyo 101-0022 (JP)**

(72) Inventors:
• **IBORI, Satoshi**
  **Tokyo 101-0022 (JP)**
• **SASAKI, Yasushi**
  **Tokyo 101-0022 (JP)**
• **TOMIYAMA, Kiyotaka**
  **Tokyo 101-0022 (JP)**

(74) Representative: **Moore, Graeme Patrick et al**
**Mewburn Ellis LLP**
**City Tower**
**40 Basinghall Street**
**London EC2V 5DE (GB)**

(54) **POWER CONVERSION DEVICE AND POWER CONVERSION DEVICE CONTROL METHOD**

(57)    The present invention addresses the problems of the increase of leakage current and noise failure induced in a peripheral device, which are attributable to a steep dV/dt because when a power conversion device is configured using a wide-bandgap semiconductor element, the turn-on speed and turn-off speed are extremely fast. A power conversion device comprises: a converter for converting an AC voltage to a DC voltage; a DC intermediate circuit for smoothing the DC voltage converted by the converter; an inverter for converting the DC voltage smoothed by the DC intermediate circuit to an AC voltage; a gate drive circuit for driving a semiconductor switching element in the inverter; a current detector for detecting current flowing through the power conversion device; and a control circuit for detecting each current component value from the current detected by the current detector and for, based on the detected each current component value or the power factor obtained from the each current component value, changing the gate resistance value of the gate drive circuit.

FIG.8

**Description**

TECHNICAL FIELD

The present invention relates to a power conversion device and a power conversion device control method.

BACKGROUND ART

In recent years, as wide-bandgap semiconductor elements having performance leapfrogging the solid-state property value limit of Silicon (Si), materials such as silicon carbide (SiC) and gallium nitride (GaN) have been getting a lot of attention, and are expected to be next generation power semiconductor elements.

These materials are semiconductor elements also having characteristics of about ten times in terms of dielectric breakdown voltage, about three times in terms of thermal conductivity, two times in terms of a melting point, and about two times in terms of saturation electron velocity in comparison with Si. Especially, because they have high dielectric breakdown voltage, they allow a drift layer to secure withstand voltage to be as thin as about one-tenth, and allow the on-voltage of a power semiconductor to be lowered.

This means that a power semiconductor comprised of these materials can substantially reduce generation loss in comparison with an IGBT (silicon), a conventional representative power semiconductor element, and thus it is expected that substantial miniaturization of a power conversion device can be achieved.

Claim 1 in Patent Literature 1 discloses "a semiconductor switching device that makes a gate resistance value of a switching element a value R1 if current detected by current sense is equal to or less than a prescribed value, makes the gate resistance value a value R2 smaller than R1 if the current detected by the current sense exceeds the prescribed value and if temperature detected by temperature sense exceeds a prescribed temperature, and makes the gate resistance value of the switching element the value R1 if the current detected by the current sense exceeds the prescribed value and if the temperature detected by the temperature sense equals to or less than the prescribed temperature."

Claims in Patent Literature 2 disclose "an induction motor overload control device comprising detection means for detecting current supplied from an inverter to an induction motor and for detecting a component proportional to an effective component from the detected current, determination means for determining which operation mode the induction motor is in, a power running mode or regenerative mode, and means for gradually reducing an output frequency and output voltage of the inverter according to a prescribed time constant if the detected effective component exceeds a predetermined limitation value at the time of power running detection by the determination means."

CITATION LIST

PATENT LITERATURE

Patent Literature 1: Japanese Patent. No. 3820167
Patent Literature 2: JP-B-1992-40960

SUMMARY OF INVENTION

TECHNICAL PROBLEM

In Patent Literature 1, "Advantageous Effects of Invention" at the paragraph [0018] says "noise occurrence is reduced by increasing a gate resistance value if load current is equal to or less than a prescribed value, switching loss is reduced and thermal destruction is prevented by reducing the gate resistance if the load current exceeds the prescribed value and if element temperature exceeds a prescribed temperature. Even if the load current exceeds the prescribed value, if the element temperature is equal to or less than the prescribed temperature, it is intended to reduce noise rather than reducing switching loss by increasing the gate resistance."

A power semiconductor switching element has tendency for their switching speed to slow even if the gate resistance value is the same, as the element temperature goes up or current flowing through the elements increases. In other words, if the current flowing through the elements is smaller, the switching speed is faster and the noise level is higher.

A power semiconductor switching element uses a scheme to change gate resistance on the basis of load current and element temperature, and need a temperature detector to detect the temperature of the switching elements. However, power conversion devices do not necessarily contain a temperature detector. For example, power conversion devices that adopt a natural cooling system and are not equipped with a cooling fan do not contain a temperature detector.

Prior Art at the paragraph [0002] discloses "devices using a semiconductor switching element are required to conduct high-speed switching in recent years, and are progressing toward higher speed, but generate noise coming along with it, which is causing a growing problem in a surrounding environment." In order to prevent induced malfunction (EMC (Electro Magnetic Compatibility) problem) of a flowmeter, a manometer or a variety of sensors that are situated in the vicinity of a power conversion device by noise due to steep dV/dt of the switching element, there is a need to gently control dV/dt.

Generally, the temperature time constant of a chip itself of a switching element is short. Detection of the temperature of a chip itself requires a special chip having a diode for temperature detection on the chip of the switching element, and the chip becomes expensive. On the other hand, because the thermal time constant of a cooling body is long, detection of an overload by a temperature detector mounted on the cooling body requires a certain time (normally tens of seconds to tens of minutes, depending on the thermal time constant of the cooling body). Therefore, there is a problem of being difficult to immediately detect an overload and change gate resistance.

In other words, because the temperature detection cannot be performed immediately, there is a problem in which changing the gate resistance gets late, steep dV/dt cannot be restrained, and malfunction by noise due to dV/dt during restraining dV/dt occurs in a flowmeter, a manometer or a variety of sensors that are situated in the vicinity of a power conversion device and operating with a quick response electric signal.

Furthermore, in a switching element constituting part of an inverter, and a freewheeling diode connected in parallel with the switching element, for example, if an on-load power factor is 0.8, 80% of output current from the power conversion device averagely flows through the switching element, and remaining 20% flows through the freewheeling diode. In the state of current flowing through the freewheeling diode, the electric potential change dV/dt of the switching element changes depending on the characteristic of the freewheeling diode, but does not depend on the characteristic of the switching element itself (in this case, a lower arm UN of a U phase) through which current is not flowing.

In other words, only the magnitude of output current of the power conversion device and the detection temperature do not make clear an effective current component or a power factor, and therefore a ratio of current flowing through the switching element to current flowing through the freewheeling diode is not clear; thus there is a problem of being unable to perform appropriate gate control corresponding to a load factor.

Especially, in the case where a power conversion device is configured using a wide-bandgap semiconductor element, a high dielectric breakdown voltage characteristic, which is a characteristic of wide-bandgap semiconductor elements, allows a drift layer to secure withstand voltage to be as thin as about one-tenth, and allows on-voltage of a power semiconductor to be lowered, and thereby substantial loss reduction is expected, but on the other hand, extremely fast on-speed and off-speed, which is a characteristic of wide-bandgap semiconductor elements, induces further increase in leakage current or noise failure to a peripheral apparatus due to steep dV/dt, and thereby causing a problem of making noise failure actual.

SOLUTION TO PROBLEM

In order to achieve the above-described object, provided is a power conversion device comprising: a converter for converting an AC voltage to a DC voltage; a DC intermediate circuit for smoothing the DC voltage converted by the converter; an inverter for converting the DC voltage smoothed by the DC intermediate circuit to an AC voltage; a gate drive circuit for driving a semiconductor switching element in the inverter; a current detector for detecting current flowing through the power conversion device; and a control circuit for detecting a current component value from the current detected by the current detector and for changing a gate resistance value of the gate drive circuit on the basis of the detected current component value or a power factor value obtained from the current component value.

ADVANTAGEOUS EFFECTS OF INVENTION

The present invention can provide a power conversion device and a power conversion device control method that suppress leakage current due to dV/dt and suppress malfunction induction by noise due to dV/dt to a flowmeter, a manometer or a variety of sensors situated in the vicinity of the power conversion device.

BRIEF DESCRIPTION OF DRAWINGS

[Fig. 1] Fig. 1 is a schematic configuration diagram of a power conversion device according to the present application.
[Fig. 2(a)] Fig. 2(a) is a block diagram of sensorless vector control of the power conversion device according to the present application (first aspect).

[Fig. 2(b)] Fig. 2(b) is a block diagram of with-sensor vector control of the power conversion device according to the present application (second aspect).

[Fig. 2(c)] Fig. 2(c) is a vector decomposition diagram into an excitation current component Id and a torque current component Iq orthogonal to it.

[Fig. 3] Fig. 3 is a timing diagram to detect effective current of an induction motor.

[Fig. 4] Fig. 4 is an effective current comparison circuit in the power conversion device according to the present application (third aspect).

[Fig. 5] Fig. 5 is a configuration example of a control circuit and a gate drive circuit in the power conversion device according to the present application (fourth aspect).

[Fig. 6] Fig. 6 is a gate drive circuit in the power conversion device according to the present application (fifth aspect).

[Fig. 7] Fig. 7 is a gate drive circuit in the power conversion device according to the present application (sixth aspect).

[Fig. 8] Fig. 8 is a gate drive circuit in the power conversion device according to the present application (seventh aspect).

[Fig. 9] Fig. 9 is a waveform diagram of $dV_{DS}/dt$ of a wide-bandgap semiconductor element in the present application.

[Fig. 10] Fig. 10 is another main circuit configuration diagram of the power conversion device in the present application.

[Fig. 11] Fig. 11 is a simplified equivalent circuit of a PM motor.

[Fig. 12] Fig. 12 is a vector diagram in the case of the power conversion device controlling the PM motor.

[Fig. 13] Fig. 13 is a PM motor control block diagram of the power conversion device according to the present application (eighth aspect).

[Fig. 14] Fig. 14 is an example of a correlation data table between a torque current reference setting value (absolute value) and gate composite resistance (ninth aspect).

DESCRIPTION OF EMBODIMENTS

EMBODIMENT 1

Hereinafter, the present application will be explained in reference to the drawings. Common configuration in the figures is given the same reference numbers. Furthermore, the present application is not limited to shown examples.

An aspect in Embodiment 1 of a power conversion device according to the present application will be explained below in reference to the figures.

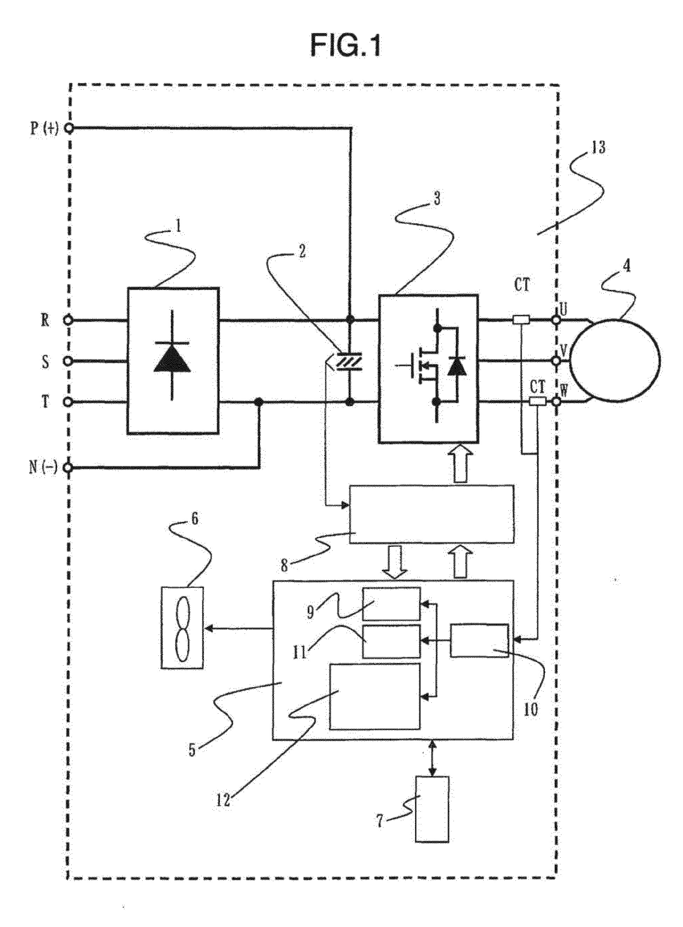

Fig. 1 is a schematic configuration diagram of a power conversion device 13 in this embodiment.

It is supposed that an AC power supply is used as any input power supply, and reference numeral 1 denotes a converter for converting AC power to DC power, 2 denotes a smoothing capacitor in a DC intermediate circuit, 3 denotes an inverter for converting DC power to AC power having any frequency, and 4 denotes an induction motor.

Reference numeral 6 denotes a cooling fan for cooling power modules inside the converter and the inverter, 7 denotes a digital operation panel for performing setting and changing of various control data of the power conversion device and displaying of an abnormal state and a monitor state.

Reference numeral 5 is a control circuit that is equipped with a microcomputer (control computation device), that serves to control switching elements in the inverter and to manage control of the whole power conversion device, and that is configured to be able to perform control processing necessary according to various control data input from the digital operation panel 7.

Reference character CT denotes a current detector, and CTs detect line current of the U phase and W phase of the induction motor. Line current of the V phase is obtained as iv = -(iu+iw) from an AC condition (iu+iv+iw = 0).

Obviously, three CTs may be used and line current of all of the U phase, V phase and W phase may be detected.

The control circuit 5 performs control processing necessary for the whole device in addition to controlling the switching elements in the inverter 3 on the basis of various control data input by the digital operation panel 7.

Although internal configuration is omitted, the control circuit 5 is equipped with a microcomputer (control computation device) that performs computation on the basis of information from storage data in a storage unit storing various control data.

Reference numeral 8 drives the switching elements in the inverter, and if there is abnormality in the switching elements, it displays the abnormality on the digital operation panel 7.

Inside the gate drive circuit 8, mounted is a switching regulator circuit (DC/DC converter) that generates a variety of DC voltage necessary to operate the power conversion device, and supplies it to various configuration.

Reference numeral 9 is comprised of an effective current component detection circuit and an effective current comparison circuit, 10 denotes a current detection circuit, 11 is comprised of an effective current component and ineffective current component detection circuit, and a power factor computation and comparison circuit, and 12 denotes a vector control circuit. Reference numeral 13 denotes a power conversion device comprised of a converter, an inverter, and the like. Inside the inverter 3, a SiC-MOSFET as a representative wide-bandgap semiconductor element is mounted.

Various control data of the power conversion device can be set and changed from the operation panel 7. The operation panel 7 is provided with a display unit capable of abnormality display, and abnormality is displayed on the display unit when the abnormality in the power conversion device is detected.

The operation panel 7 in the embodiment is not limited to a particular type, but taking operability for a device user as a digital operation panel into consideration, it is configured such that the user can operate it while looking at the display on the display unit.

The display unit does not necessarily need to have an integral structure with the operation panel 7, but it is desirable to have the integral structure so as to enable an operator of the operation panel 7 to operate it while looking at the display.

Various control data of the power conversion device input from the operation panel 7 is stored in an unshown storage unit.

In the case of supplying DC power instead of AC power as input power, it is only necessary to connect the (+) side of a DC power supply to a DC terminal P(+) side, and to connect the (-) side of the DC power supply to a DC terminal N(-) side. Furthermore, it may be good to connect AC terminals R, S and T together, to connect the (+) side of the DC power supply to this connection point, and to connect the (-) side of the DC power supply to the DC terminal N(-) side. Conversely, it may be good to connect the (+) side of the DC power supply to the DC terminal P(+) side, to connect the AC terminals R, S and T together, and to connect the (-) side of the DC power supply to this connection point.

EMBODIMENT 2

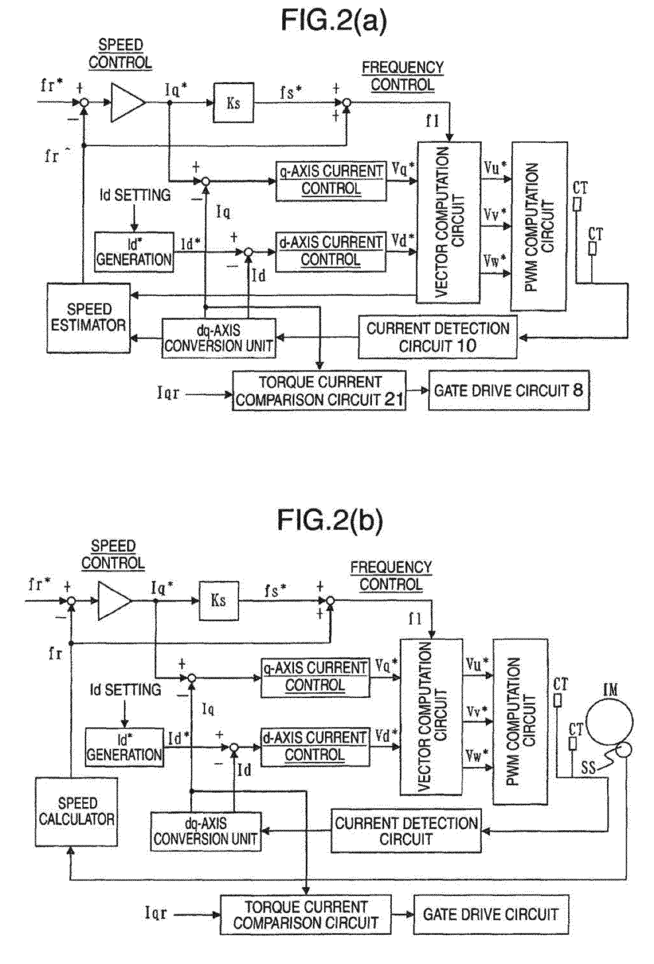

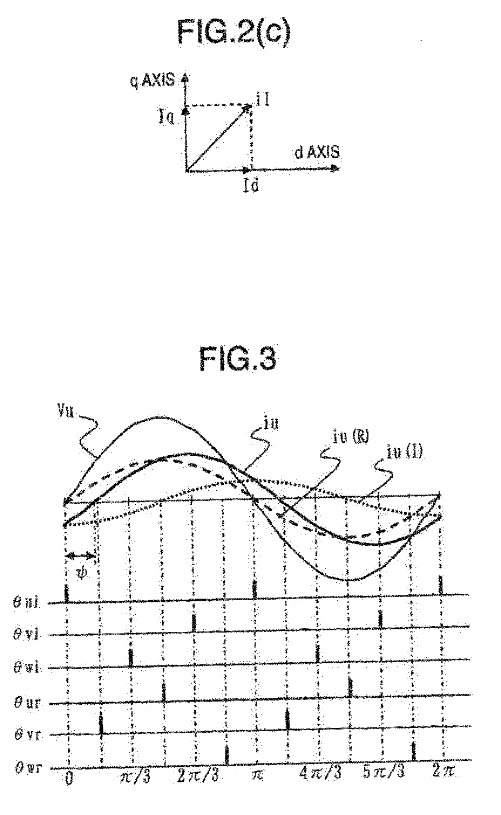

Fig. 2(a) is a block diagram of sensorless vector control of the power conversion device according to the present application (first aspect). A current detection circuit and a gate drive circuit in Fig. 2(a) correspond to the current detection circuit 10 and the gate drive circuit 8 shown in Fig. 1, respectively, and other configuration in Fig. 2 is detailed configuration of the vector control circuit 12 inside the control circuit 5 in Fig. 1.

Sensorless vector control is called DC-machine-like control of an induction motor. Electric constant values such as primary-side resistance in the induction motor are indispensable electric constant values for execution of sensorless vector control, and therefore they are generally stored in a memory (unshown) inside the power conversion device in advance. In addition, the electric constant values such as primary-side resistance in the induction motor may be actually measured by means of an auto-tuning function.

In fact, it is up to a user of the power conversion device to decide which will be used, the values stored in advance in the memory inside the power conversion device or the values actually measured by means of the auto-tuning function.

The current detectors CTs detect the line current of the induction motor, a dq-axis conversion unit converts the detected current to current on orthogonal "d" and "q" axes, and the resulting current is decomposed into an excitation current component Id and a torque current component Iq.

As shown in Fig. 2(c), the dq-axis conversion unit performs vector decomposition of the detected current (primary current) i1 into the excitation current component Id and the torque current component Iq orthogonal to it (i1 = Id+jIq).

In this case, if the operation mode of the induction motor is regarded as an electric operation mode when the torque current component Iq is positive (Iq>0), it is understandable that the operation mode is a regenerative mode when the torque current component Iq is negative (Iq<0). In other words, the sign of the torque current component Iq enables determination of which state the induction motor is in, an electric operation state (motor) or a regenerative state (generator).

If Iq is smaller than Iqr, an AC machine is determined to be close to an unloaded state, and the gate resistance of the gate drive circuit is increased, and if Iq is larger than Iqr, the AC machine is determined to be in a loaded state, and the gate resistance of the gate drive circuit is reduced.

As a matter of course, a torque current command Iq* may be used instead of the detected torque current component Iq.

As a matter of course, because the orthogonal d-q axes are imaginary axes, it does not limit its name to d-q axes (d axis and q axis), and may be α-β axes as long as each axis is orthogonal to the other. That is, even if the excitation current component Id and the torque current component Iq are changed to an excitation current component Iα and a torque current component Iβ, the intention of the present application is not changed.

EMBODIMENT 3

Fig. 2(b) is a block diagram of with-sensor vector control of the power conversion device according to the present application (second aspect).

Configuration common to and the same functions as Fig. 2(a) are given the same reference numbers.

A point different from Fig. 2(a) is that as means to detect the speed of the induction motor, a speed detector SS detects actual speed fr without using a speed estimator.

In Figs. 2(a) and (b), a torque current comparison circuit compares the detected torque current component Iq with the preset torque current reference value Iqr. If Iq is smaller than Iqr, an AC machine is determined to be close to an unloaded state, and the gate resistance of the gate drive circuit is increased, and if Iq is larger than Iqr, the AC machine is determined to be in a loaded state, and the gate resistance of the gate drive circuit is reduced.

As a matter of course, a torque current command Iq* may be used instead of the detected torque current component Iq.

Fig. 3 is a timing diagram to detect effective current of the induction motor.

Primary current i1 flowing through the primary side of the induction motor is described as follows.

$$i1 = I1(r) + j\{I1(i)\}$$

That is, the primary current i1 is represented by vectorial sum of an effective current component I1(r) and an ineffective current component I1(i).

In Fig. 3, for example, reference character $\Phi$ denotes a power factor angle between primary-side phase voltage Vu and primary-side u-phase current iu, and is represented as follows:

$$\tan \Phi = I1(i)/I1(r) \text{ ---Expression (1),}$$

or

$$\cos \Phi = I1(r)/I1 \text{ ---Expression (2),}$$

or

$$\cos \Phi = I1(r)/[\{I1(r)\}^2 + \{I1(i)\}^2]^{1/2} \text{ ---Expression (3).}$$

In this case, if the operation mode of the induction motor is regarded as an electric operation mode when the effective current component I1(r) is positive {I1 (r)>0}, it is understandable that it is a regenerative mode when the effective current component I1(r) is negative {II(r)<0}. In other words, the sign of the effective current component I1(r) enables determination of which state the induction motor is in, an electric operation state (motor) or a regenerative state (generator).

Alternatively, if the power factor angle $\Phi$ is 0°-90°, the inductive motor is in the electric operation mode, and if the power factor angle $\Phi$ is 90°-180°, it is in the regenerative mode. In other words, the power factor angle $\Phi$ enables determination of which state the induction motor is in, an electric operation state (motor) or a regenerative state (generator).

In primary-side u-phase current iu, its effective current component Iu(r) is naturally the same phase as its phase voltage Vu, and its ineffective current component Iu(i) is naturally in a phase state behind the phase voltage Vu by $\pi/2(90°)$. This relation does not depend on the state of a load on the induction motor. That is, this relation always holds true regardless of whether an induction motor or an induction generator is an unloaded state or a loaded state.

In other words, on the basis of the phase voltage Vu, current at the time points of $\pi/2$ (90°) and $3\pi/2$ (270°) are $\pm$ peak values of the effective current component Iu(r), and current at the time points of 0 (0°) and $\pi$ (180°) indicates $\pm$ peak values of the ineffective current component Iu(i).

In other words, on the basis of the phase voltage Vu, the following phase sampling time points represent the effective current component of the u phase and ineffective current component of the u phase.

- Time points of $\pi/2$ and $3\pi/2$: Iu(i) = 0 → u-phase effective current component Iu(r), and
- Time points of 0 and $\pi$: Iu(r) = 0 → u-phase ineffective current component Iu(i).

In the case of three-phase AC each phase having a phase difference of 120° from the other phases, v-phase current iv is in the state of being behind the u-phase current iu by $2\pi/3$ (120°) in terms of phase, and w-phase current iw is in the state of being behind the u-phase current iu by $4\pi/3$ (240°) in terms of phase. Consequently, on the basis of the phase voltage Vu, the following phase sampling time points represent the effective current component of the v phase and the ineffective current component of the v phase.

- Time points of $\pi/6$ and $7\pi/6$: Iv(i) = 0 → v-phase effective current component Iv(r), and
- Time points of $2\pi/3$ and $5\pi/3$: Iv(r) = 0 → v-phase ineffective current component Iv(i).

Furthermore, on the basis of the phase voltage Vu, the following phase sampling time points represent the effective current component of the w phase and the ineffective current component of the w phase.

- Time points of $5\pi/6$ and $11\pi/6$: Iw(i) = 0 → w-phase effective current component Iw(r),
- Time points of $\pi/3$ and $4\pi/3$: Iw(r) = 0 → w-phase ineffective current component Iw(i).

More specifically, it is obvious that on the basis of the phase voltage Vu: if primary-side u-phase current is detected by sampling at time points $\theta$ui of 0 (0°) and $\pi$ (180°), the u-phase ineffective current component Iu(i) can be detected; if primary-side v-phase current is detected by sampling at time points $\theta$vi of $2\pi/3$ (120°) and $5\pi/3$ (300°), the v-phase ineffective current component Iv(i) can be detected; and if primary-side w-phase current is detected by sampling at time points $\theta$wi of $\pi/3$ (60°) and $4\pi/3$ (240°), the w-phase ineffective current component Iw(i) can be detected.

As stated above, an explanation is given for a principle that ineffective current components can be detected if current at particular phases is detected on the basis of the u-phase phase voltage Vu, but obviously, the basis may be v-phase phase voltage Vv or the basis may be w-phase phase voltage Vw.

It is obvious that even if the phase voltage Vu and the phase voltage Vv and the phase voltage Vw are the bases, difference is only particular phases to be sampled by phase voltage acting as the basis, and $\pm$ peak values of the ineffective current component are the same as long as there is no mistake about the particular phase points to be sampled.

In other words, if motor current in the vicinity of particular phases ($\theta$ui, $\theta$vi and $\theta$wi) on the basis of the u-phase phase voltage Vu is detected, the ineffective current component I1(i) can be detected. Obviously, detection is not limited to detect motor current in the vicinity of all the particular phase points $\theta$ui, $\theta$vi and $\theta$wi, and it may work to detect the ineffective current component I1(i) which is motor current at a time point only in the vicinity of the particular phase $\theta$ui, or at a time point only in the vicinity of the particular phase $\theta$vi, or at a time point only in the vicinity of the particular phase $\theta$wi.

Furthermore, among the phase points $\theta$ui, $\theta$vi and $\theta$wi, it may work to detect the ineffective current component I1 (i) which is motor current in the vicinity of particular two phase points (for example, $\theta$ui and $\theta$vi).

In the same manner, on the basis of the phase voltage Vu, if primary-side u-phase current is detected by sampling at time points $\theta$ur of $\pi/2$ (90°) and $3\pi/2$ (270°), the u-phase effective current component Iu(r) can be detected; if primary-side v-phase current is detected by sampling at time points $\theta$vr of $5\pi/6$ (150°) and $11\pi/6$ (330°), the v-phase effective current component Iv(r) can be detected; and if primary-side w-phase current is detected by sampling at time points $\theta$wr of $\pi/6$ (30°) and $7\pi/6$ (210°), the w-phase effective current component Iw(r) can be detected.

As stated above, an explanation is given for a principle that effective current components can be detected if current at particular phases is detected on the basis of the u-phase phase voltage Vu, but obviously, the basis may be the v-phase phase voltage Vv or the basis may be the w-phase phase voltage Vw.

Even if the phase voltage Vu and the phase voltage Vv and the phase voltage Vw are the bases, difference is only particular phases to be sampled by phase voltage acting as the basis, and $\pm$ peak values of the effective current component are the same as long as there is no mistake about the particular phase points to be sampled.

In other words, if motor current in the vicinity of particular phases ($\theta$ur, $\theta$vr and $\theta$wr) on the basis of the u-phase phase voltage Vu is detected, the effective current component I1(r) can be detected. Obviously, detection is not limited to detect motor current in the vicinity of all the particular phase points $\theta$ur, $\theta$vr and $\theta$wr, and it may work to detect the effective current component I1(r) which is motor current at a time point only in the vicinity of the particular phase $\theta$ur, or at a time point only in the vicinity of the particular phase $\theta$vr, or at a time point only in the vicinity of the particular phase $\theta$wr.

Furthermore, among the phase points $\theta$ur, $\theta$vr and $\theta$wr, it may work to detect the effective current component I1 (r) which is motor current in the vicinity of particular two phase points (for example, $\theta$ur and $\theta$vr).

EMBODIMENT 4

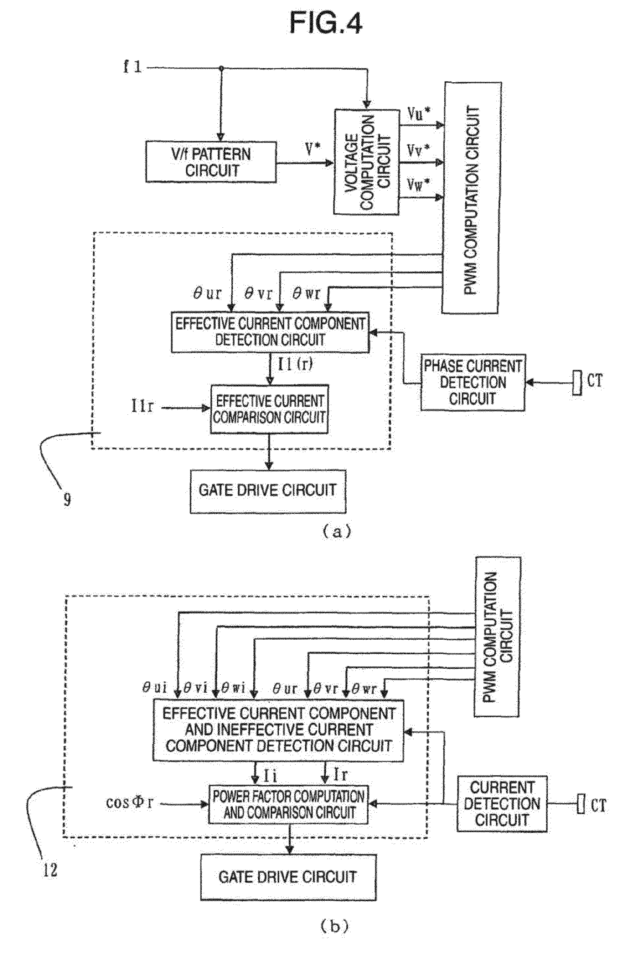

Fig. 4 is an effective current comparison circuit in the power conversion device according to the present application (third aspect).

Fig. 4(a) is a block configuration diagram for an effective current component detection circuit to detect an effective current component value from phase current of an AC machine, and for an effective current comparison circuit to change gate resistance on the basis of the effective current component value. A circuit 9 is comprised of an effective current component detection circuit and an effective current comparison circuit.

A voltage computation circuit computes three-phase output phase voltage Vu*, Vv* and Vw* from an output frequency command f1 input into the power conversion device and output voltage V* for the output frequency command, and speed control of an induction motor is performed according to a PWM computation result.

More specifically, AC voltage as a modulation wave of each phase at a PWM computation circuit is represented by the following expressions.

$$\bullet\ Vu = Vu^* \cdot \sin(\omega 1 \cdot t);$$

$$\bullet\ Vv = Vv^* \cdot \sin(\omega 1 \cdot t - 2\pi/3);\ \text{and}$$

$$\bullet\ Vw = Vw^* \cdot \sin(\omega 1 \cdot t - 4\pi/3),$$

where the value of $\omega 1$ is $\omega 1 = 2\pi \cdot f1$.

For a detection signal from a phase current detection circuit, the effective current component detection circuit detects an effective current component I1 (r) from motor phase current in the vicinity of particular phases ($\theta$ur, $\theta$vr and $\theta$wr) on the basis of the u-phase phase voltage Vu of the PWM computation circuit. The effective current comparison circuit compares the detected effective current component value I1(r) with a preset effective current reference value I1r.

If I1 (r) is smaller than I1r an AC machine is determined to be close to an unloaded state, and the gate resistance of a gate drive circuit is increased, and If I1(r) is larger than I1r the AC machine is determined to be in a loaded state and the gate resistance of the gate drive circuit is reduced.

Fig. 4(b) is a block configuration diagram for an effective current component and ineffective current component detection circuit to detect an effective current component value and an ineffective current component value from phase current of the AC machine, and for a power factor computation and comparison circuit to change gate resistance on the basis of a power factor value. Although a V/f pattern circuit and a voltage computation circuit depicted in Fig. 4(a) are not shown, but it has similar configuration.

A circuit 11 is comprised of the effective current component and ineffective current component detection circuit, and the power factor computation and comparison circuit.

For a detection signal from the phase current detection circuit, the effective current component and ineffective current component detection circuit detects an effective current component I1(r) from motor phase current in the vicinity of particular phases ($\theta$ur, $\theta$vr and $\theta$wr) on the basis of the u-phase phase voltage Vu of the PWM computation circuit, and detects an ineffective current component I1(i) from motor current in the vicinity of particular phases ($\theta$ui, $\theta$vi and $\theta$wi) on the basis of the u-phase phase voltage Vu of the PWM computation circuit. The power factor computation and comparison circuit computes a power factor cos$\Phi$ from the detected effective current component value I1(r) and ineffective current component I1(i), and phase current 11, and compares it with a preset power factor reference value cos$\Phi$r.

If cos$\Phi$ is smaller than cos$\Phi$r, the AC machine is determined to be close to the unloaded state, and the gate resistance of the gate drive circuit is increased, and if cos$\Phi$ is larger than cos$\Phi$r, the AC machine is determined to be in the loaded state and the gate resistance of the gate drive circuit is reduced. In other words, the gate resistance is changed according to a load factor.

The power factor cos$\Phi$ can be obtained by Expression 1 or Expression 2 or Expression 3.

EMBODIMENT 5

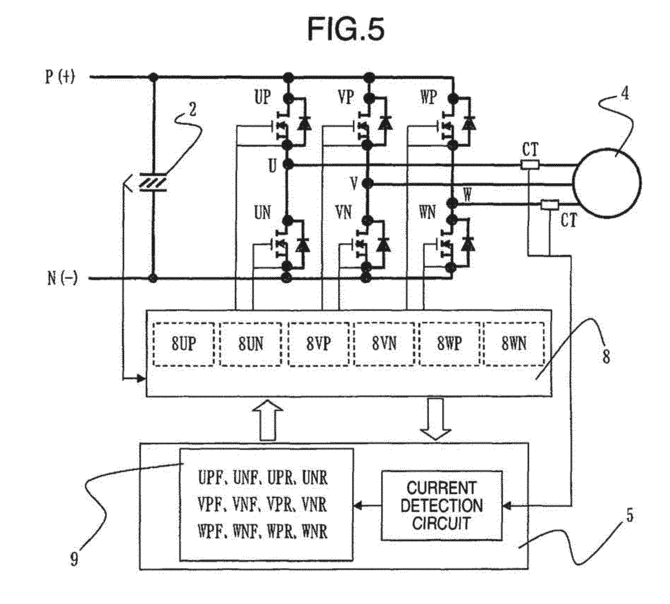

Fig. 5 is a configuration example of a control circuit and a gate drive circuit in the power conversion device according to the invention (fourth aspect).

Configuration common to and the same functions as Fig. 1 are also given the same reference numbers.

A circuit 9 in a control circuit 5 is configured, on the basis of a detected effective current component value, to give a gate drive circuit 8 a signal to change gate resistance, i.e., to give the U phase commands UPF, UNF, UPR and UNR, to give the V phase commands VPF, VNF, VPR and VNR, and to give the W phase commands WPF, WNF, WPR and WNR, and thereby to drive switching elements UP, UN, VP, VN, WP and WN of the respective phases.

EMBODIMENT 6

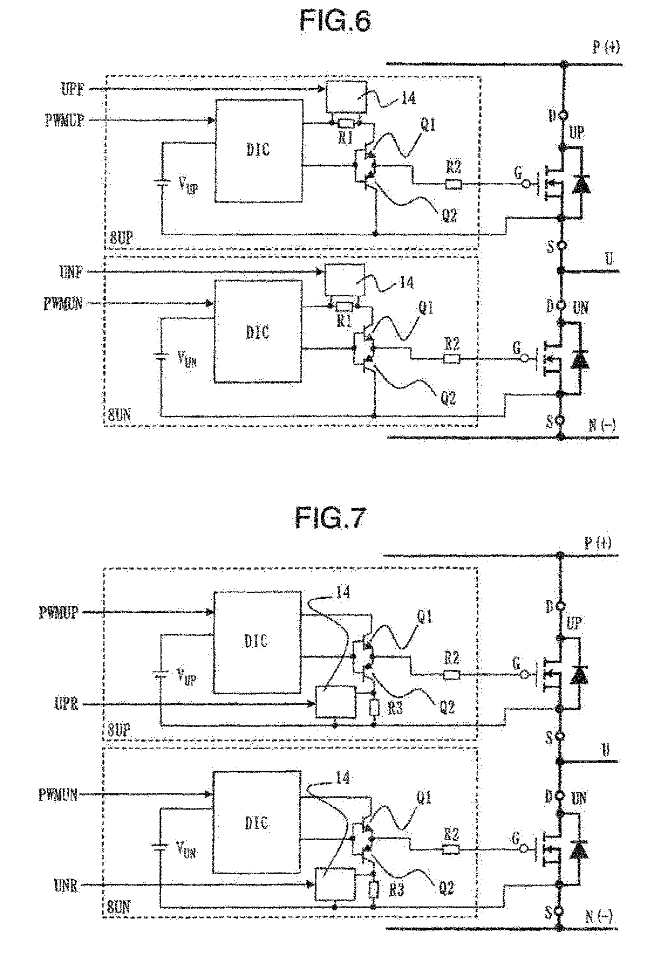

Fig. 6 is a gate drive circuit in the power conversion device according to the present application (fifth aspect).

Configuration common to and the same functions as Fig. 1 are also given the same reference numbers.

An explanation is given for UP and UN made up of wide-bandgap semiconductor elements SiC-MOSFET as switching elements constituting part of U-phase upper and lower arms.

Reference character 8UP denotes a gate drive circuit in the U-phase upper arm, and 8UN a gate drive circuit in the U-phase lower arm. Reference character DIC denotes a drive IC. Reference character Q1 denotes a transistor that turns on (hereinafter called forward bias) the SiC-MOSFET UP and UN, and reference character R1 denotes a forward bias resistor. Reference character Q2 denotes a transistor that turns off (hereinafter called reverse bias) the SiC-MOSFET UP and UN, and reference character R2 denotes a reverse bias resistor. R2 is a resistor that conducts electricity at the times of both forward bias and reverse bias.

Reference character PWMUP denotes a PWM signal for the U-phase upper arm, PWMUN denotes a PWM signal for the U-phase lower arm, UPF denotes a signal for a variable resistance circuit in the U-phase upper arm, and UNF denotes a signal for a variable resistance circuit in the U-phase lower arm.

If Iq explained in Figs. 2(a) and (b) is smaller than Iqr, an AC machine is determined to be close to an unloaded state, and UPF and UNF turn off the variable resistance circuits to increase the gate resistance of the gate drive circuits, and if Iq is larger than Iqr, the AC machine is determined to be in a loaded state, and UPF and UNF turn on the variable resistance circuits to be configured to reduce the gate resistance of the gate drive circuits.

In the same manner, if I1 (r) explained in Fig. 4(a) is smaller than I1r, the AC machine is determined to be close to the unloaded state, and UPF and UNF turn off the variable resistance circuits to increase the gate resistance of the gate drive circuits, and if I1(r) is larger than I1r, the AC machine is determined to be in the loaded state, and UPF and UNF turn on the variable resistance circuits to be configured to reduce the gate resistance of the gate drive circuits. The variable resistance circuits have configuration in which, for example, a switch SW and a resistor RS are series-connected. Therefore, "UPF turns on the variable resistance circuit" means that it turns on the switch SW. If the switch SW is turned on, unshown serial resistance RS and forward bias resistance R1 are connected in parallel, and therefore composite resistance Rt becomes smaller than R1 {Rt = R1*RS/(R1+RS)<R1}.

As a matter of course, the number of switches SW and the number of serial resistors RS are not limited, and adoption of configuration in which the serial resistor RS is series-connected with the forward bias resistor R1 does not change the intention of the present application.

This example is an embodiment to change the gate resistance of only the forward bias circuits in the gate drive circuits 8UP and 8UN on the basis of I1(r).

Naturally, the V phase and the W phase also have circuit configuration that operates in the same manner as the U phase.

EMBODIMENT 7

Fig. 7 is a gate drive circuit in the power conversion device according to the present application (sixth aspect).

Configuration common to and the same functions as Fig. 6 are also given the same reference numbers.

Reference character Q1 denotes a forward bias transistor of SiC-MOSFET UP and UN, and R2 a forward bias resistor. Reference character Q2 denotes a reverse bias transistor of the SiC-MOSFET UP and UN, and R3 a reverse bias resistor. R2 is a resistor that conducts electricity at the times of both forward bias and reverse bias.

If Iq explained in Figs. 2(a) and (b) is smaller than Iqr, an AC machine is determined to be close to an unloaded state, and UPR and UNR turn off variable resistance circuits to increase the gate resistance of the gate drive circuits, and if Iq is larger than Iqr, the AC machine is determined to be in a loaded state, and UPR and UNR turn on the variable resistance circuits to be configured to reduce the gate resistance of the gate drive circuits.

In the same manner, if I1 (r) explained in Fig. 4(a) is smaller than I1r the AC machine is determined to be close to the unloaded state, and UPR and UNR turn off the variable resistance circuits to increase the gate resistance of the gate drive circuits, and if I1(r) is larger than I1r, the AC machine is determined to be in the loaded state, and UPR and UNR turn on the variable resistance circuits to be configured to reduce the gate resistance of the gate drive circuits. The variable resistance circuits have configuration in which, for example, a switch SW and a resistor RS are series-connected. Therefore, "UPR turns on the variable resistance circuit" means that it turns on the switch SW. If the switch SW is turned on, unshown serial resistance RS and forward bias resistance R3 are connected in parallel, and therefore composite resistance Rt becomes smaller than R3 {Rt = R3*RS/(R3+RS)<R3}.

As a matter of course, the number of switches SW and the number of serial resistors RS are not limited, and adoption of configuration in which the serial resistor RS is series-connected with the forward bias resistor R3 does not change the intention of the present application.

This example is an embodiment to change the gate resistance of only the reverse bias circuits in the gate drive circuits 8UP and 8UN on the basis of I1(r).

Naturally, the V phase and the W phase also have circuit configuration that operates in the same manner as the U phase.

EMBODIMENT 8

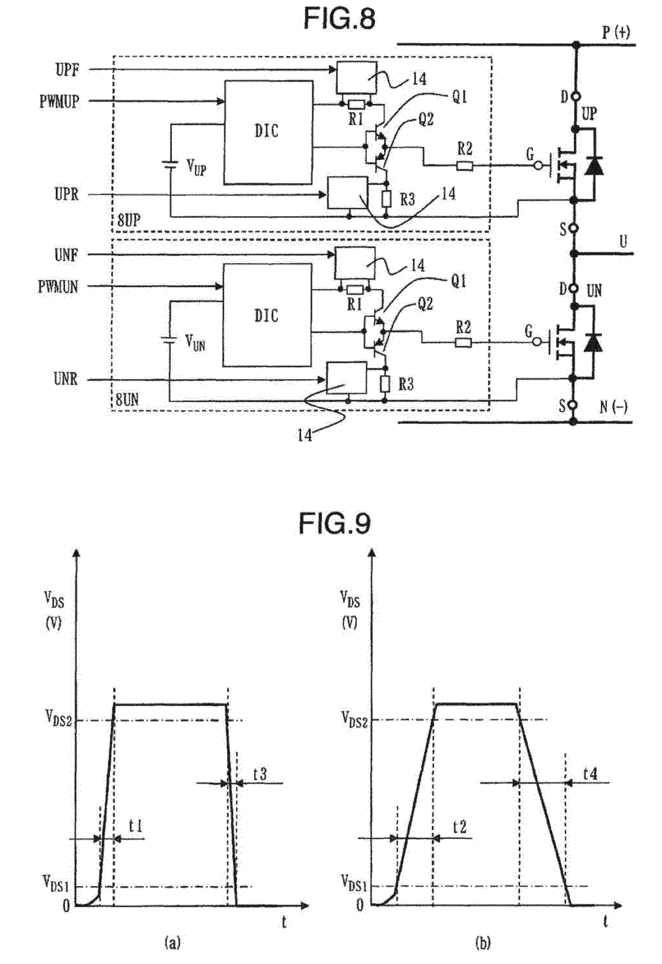

Fig. 8 is a gate drive circuit in the power conversion device according to the present application (seventh aspect).

Configuration common to and the same functions as Fig. 6 are also given the same reference numbers.

If Iq explained in Figs. 2(a) and (b) is smaller than Iqr, an AC machine is determined to be close to an unloaded state, and UPF, UNF, UPR and UNR turn off variable resistance circuits to increase the gate resistance of the gate drive circuits, and if Iq is larger than Iqr, the AC machine is determined to be in a loaded state, and UPF, UNF, UPR and UNR turn on the variable resistance circuits to be configured to reduce the gate resistance of the gate drive circuits.

In the same manner, if I1 (r) explained in Fig. 4(a) is smaller than I1r, the AC machine is determined to be close to the unloaded state, and UPF, UNF, UPR and UNR turn off the variable resistance circuits to increase the gate resistance of the gate drive circuits, and if I1(r) is larger than I1r the AC machine is determined to be in the loaded state, and UPF, UNF, UPR and UNR turn on the variable resistance circuits to reduce the gate resistance of the gate drive circuits. The variable resistance circuits have configuration in which, for example, a switch SW and a resistor RS are series-connected. Therefore, for example, "UPF turns on the variable resistance circuit" means that it turns on the switch SW. If the switch SW is turned on, unshown serial resistance RS and forward bias resistance R1 are connected in parallel, and therefore composite resistance Rt becomes smaller than R1 $\{Rt = R1*RS/(R1+RS)<R1\}$ In addition, for example, "UNF turns on the variable resistance circuit" means that it turns on the switch SW. If the switch SW is turned on, the unshown serial resistance RS and forward bias resistance R1 are connected in parallel, and therefore the composite resistance Rt becomes smaller than R3 $\{Rt = R3*RS/(R3+RS)<R3\}$.

As a matter of course, the number of switches SW and the number of serial resistors RS are not limited, and adoption of configuration in which the serial resistor RS is series-connected with the forward bias resistor R1 does not change the intention of the present application.

This example is an embodiment to change the gate resistance of both forward bias circuits and reverse bias circuits in the gate drive circuits 8UP and 8UN on the basis of Iq or I1(r) or cosΦ.

Naturally, the V phase and the W phase also have circuit configuration that operates in the same manner as the U phase.

Fig. 9 is a waveform diagram of $dV_{DS}$ /dt of a wide-bandgap semiconductor element in the present application.

Fig. 9(a) is an embodiment, for example, to change the gate resistance of both forward bias circuits and reverse bias circuits in the gate drive circuits 8UP and 8UN on the basis of Iq or I1(r) or cosΦ, and is a waveform diagram of $dV_{DS}$ /dt of the wide-bandgap semiconductor element when UPF and UNF turn on the variable resistance circuits to reduce forward bias and reverse bias gate resistance.

Fig. 9(b) is an embodiment, for example, not to change the gate resistance of both forward bias circuits and reverse bias circuits in the gate drive circuits 8UP and 8UN on the basis of Iq or I1(r) or cosΦ, and is a waveform diagram of $dV_{DS}$ /dt of the wide-bandgap semiconductor element when UPF and UNF turn off the variable resistance circuits to increase the forward bias and reverse bias gate resistance.

EMBODIMENT 9

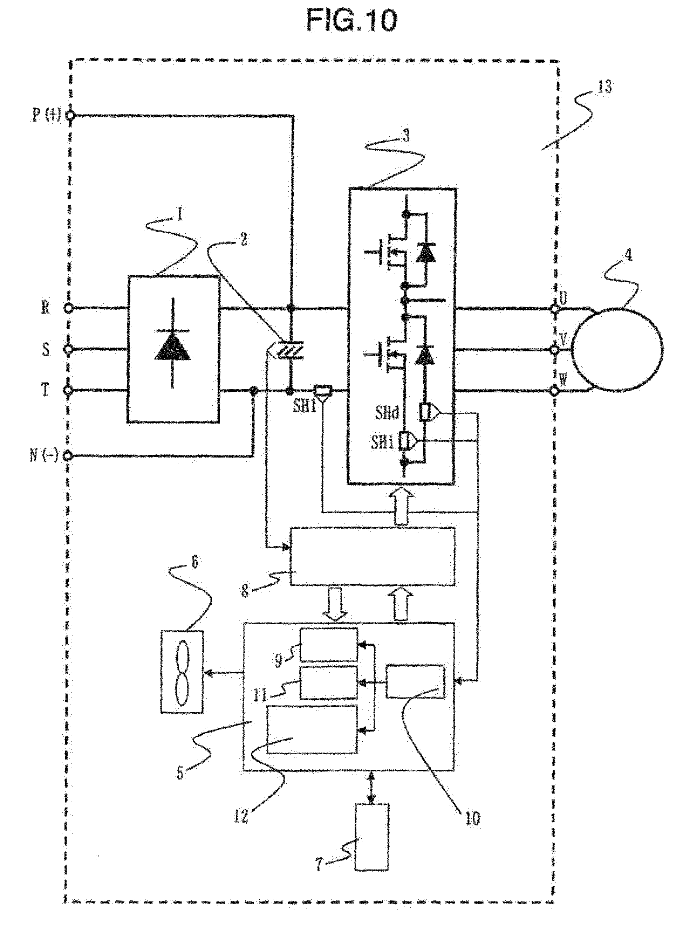

Fig. 10 is another main circuit configuration diagram of the power conversion device in the present application.

Configuration common to and the same functions as Fig. 1 are also given the same reference numbers.

Difference from Fig. 1 is detection positions by current detectors.

Reference characters SH1, SHi and SHd denote current detection shunt resistors, SH1 detects current at the N side of a DC intermediate circuit, SHi is connected with IGBTs of the U phase, V phase and W phase, which are switching elements of a lower arm constituting part of an inverter 3, and SHd is connected with diodes connected in parallel with the respective IGBTs, which are switching elements.

In other words, the shunt resistor SHi provided at a DC bus bar side of the power conversion device is a current detector for detecting composite current flowing through the IGBTs, and the shunt resistor SHd provided at the DC bus bar side of the power conversion device is a current detector for detecting composite current flowing through the diodes connected in parallel with the respective IGBTs.

The shunt resistors SHi and SHd are connected with the IGBT and the diode, respectively, in the lower arm constituting part of the U phase, but they may be connected with an IGBT and a diode, respectively, in an upper arm constituting part of the U phase to detect current. Detecting voltage of the shunt resistor SH1 or the shunt resistors SHi and SHd allows line current of each line of a motor to be indirectly detected.

Consequently, it is obvious that for a detection signal from a current detection circuit, gate resistance can be changed in the same manner as the above-described embodiments by detecting an effective current component I1(r) and an ineffective current component I1(i) from Iq obtained by a vector control circuit 12 or current in the vicinity of particular phases on the basis of the u-phase phase voltage Vu of a PMW computation circuit.

EMBODIMENT 10

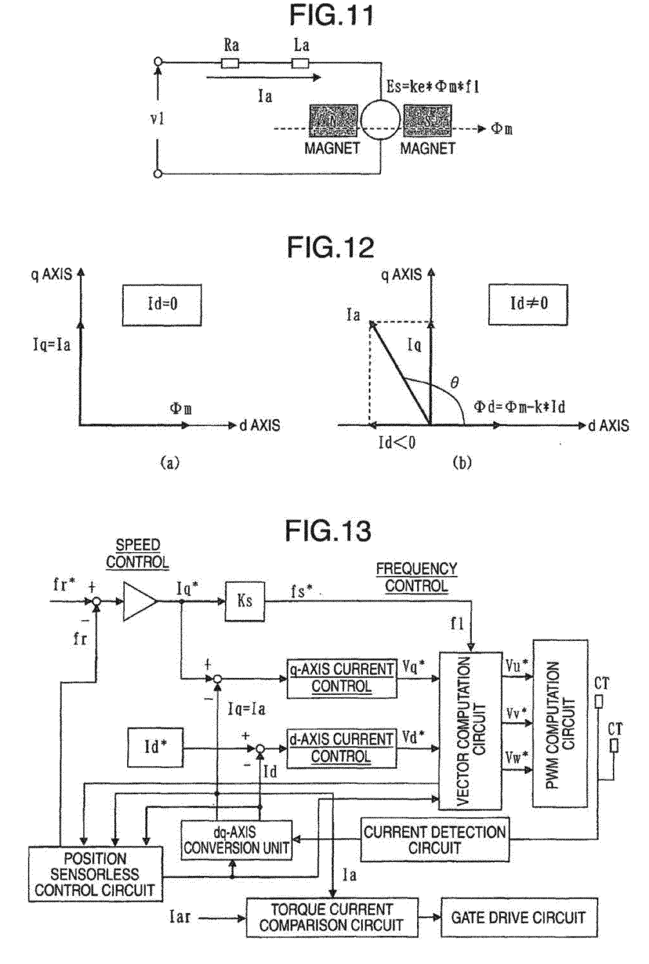

Fig. 11 is a simplified equivalent circuit of a PM motor.

It consists of armature resistance Ra, armature inductance La, armature current Ia, and speed electromotive force Ea.

Fig. 12 is a vector diagram in the case of the power conversion device controlling the PM motor.

Fig. 12(a) is the case of magnetic flux constant control, and (b) is the case of weak field control.

As control for the power conversion device to drive the PM motor, it controls the vector of current so that the armature current Ia flows through a "q" axis orthogonal to a "d" axis (electrically $\theta = 90°$), regarding the d axis as the direction of magnetic flux $\Phi m$ generated by an attached magnet.

In order to set the d axis, the magnetic flux direction generated by the magnet is estimated by means of control algorithm without using a magnetic pole position sensor.

Generation torque is represented by vector product of magnetic flux and current regardless of a DC machine or an AC machine ($T = \Phi m*I*\sin\theta$). In this case, it becomes $T = \Phi m*I*\sin 90° = \Phi m*Ia$.

In this case, the armature current Ia corresponds to the torque current component Iq explained in Fig. 2.

Consequently, the gate resistance of a gate drive circuit is changed on the basis of an armature current component in the same manner as explained in Embodiment 2.

Fig. 13 is a PM motor control block diagram of the power conversion device according to the present application (eighth aspect).

As explained in Fig. 12, it controls the vector of current flowing through a "q" axis orthogonal to a "d" axis (electrically $\theta = 90°$), regarding the d axis as the direction of magnetic flux $\Phi m$ generated by the attached magnet.

Current detectors CTs detect the line current of the PM motor, a dq-axis conversion unit converts the detected current to current on orthogonal d-q axes, and the resulting current is decomposed into an excitation current component Id and a torque current component Iq.

A d-axis current command flowing in the direction of the magnetic flux $\Phi m$ is set to Id* = 0, and a circuit for d-axis current control operates so that the detected excitation current component Id is always 0 (corresponding to the vector diagram of Fig. 12(a)). Controlled in this manner, the armature current Ia flowing through the PM motor is controlled as a torque current component Iq by operation of the circuit for q-axis current control. In other words, the armature current Ia flowing through the PM motor can be operated as a torque current component proportional to the generation torque of the motor.

In a weak field region, the d-axis current command is set to Id*<0, and the magnetic flux $\Phi m$ generated by the attached magnet is reduced ($\Phi d = \Phi m-k*Id$) (corresponding to the vector diagram of Fig. 12(b)). In order to reduce the magnetic flux $\Phi m$, the phase of the armature current Ia flowing through the PM motor should be controlled to 90° or more ($\theta>90°$).

In other words, in the same manner as Iq explained in Figs. 2(a) and (b), if Ia is smaller than preset Iar, the AC machine is determined to be close to an unloaded state, and UPF and UNF turn off the variable resistance circuits to increase the gate resistance of the gate drive circuits, and if Ia is larger than Iar, the AC machine is determined to be in a loaded state, and UPF and UNF turn on the variable resistance circuits to be configured to reduce the gate resistance of the gate drive circuits.

As a matter of course, the torque current command Iq* may be used instead of the detected armature current Ia.

Naturally, on the basis of the armature current component, the gate resistance may be changed only for the forward bias circuits in the gate drive circuits 8UP and 8UN explained in Embodiment 6, or the gate resistance may be changed only for the reverse bias circuits in the gate drive circuits 8UP and 8UN explained in Embodiment 7, or the gate resistance may be changed for both forward bias circuits and reverse bias circuits in the gate drive circuits 8UP and 8UN explained in Embodiment 8. Naturally, the V phase and the W phase also have circuit configuration that operates in the same manner as the U phase.

In the above embodiments, explanations are given in a level at which the preset Iqr, I1(r), Iar and $\cos\Phi r$ values are close to the unloaded state of the AC machine (load factor≈0), but the intention and effects of the present application are the same even if the load factor of the AC machine is, for example, 70% or below. More specifically, the Iqr, I1r Iar and $\cos\Phi r$ values are only required to be set according to a predetermined load factor.

The predetermined Iqr, I1r Iar and $\cos\Phi r$ values are only required to be obtained, by conducting a temperature test in advance, from correlation data between the Iq value and a temperature rising value of a switching element, correlation data between the I1(r) value and a temperature rising value of the switching element, correlation data between the Ia value and a temperature rising value of the switching element, and correlation data between the $\cos\Phi$ value and

a temperature rising value of the switching element. For example, if the temperature rising value of the switching element exceeds a stipulated value when the Iq value exceeds 70% of a rated torque current value Iqrr in a temperature test in advance, it is only necessary to determine in advance that Iqr is Iqr = 70%. The I1(r), Iar and cosΦr values are also required to be determined in advance from a temperature test in advance in the same manner.

EMBODIMENT 11

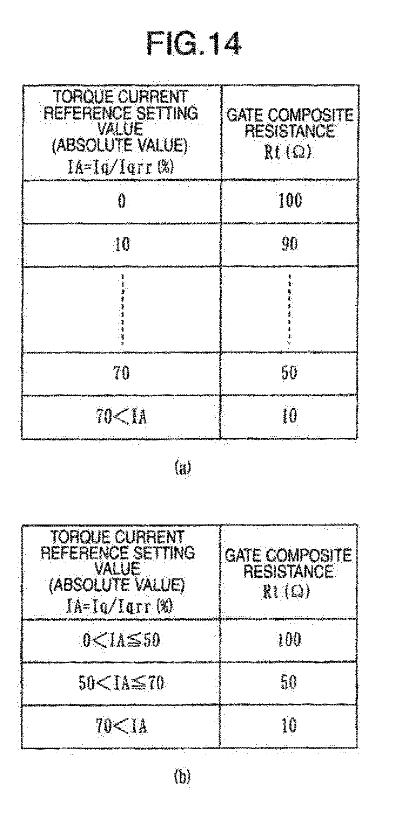

Fig. 14 is an example of a correlation data table between a torque current reference setting value (absolute value) and gate composite resistance (ninth aspect).

A torque current reference setting value (absolute value) IA (= Iq/Iqrr) and gate composite resistance Rt corresponding to it are stored in a nonvolatile memory in advance from correlation data between the Iq value and a temperature rising value of a switching element obtained in a temperature test in advance.

A user sets the torque current reference setting value (absolute value) IA from the digital operation panel 7 shown in Fig. 1. The gate composite resistance Rt corresponding to the setting value IA is read out from the nonvolatile memory, and a serial resistance value RS corresponding to the gate composite resistance value is selected.

Fig. 14(a) is an example in which individual gate composite resistance Rt corresponding to an individual setting value IA is stored in the nonvolatile memory, and (b) is an example in which gate composite resistance Rt corresponding to a setting value IA of which the range is limited is stored in the nonvolatile memory.

The load factor of a motor is selected by the user in light of a facility, and the motor is not necessarily operated at a load factor 100%. Therefore, a fact that the user can freely select the gate resistance value according to the load factor of the facility is truly an effective method from a view point of EMC (Electro Magnetic Compatibility).

As a matter of course, the intention of the present application is not changed: even if the configuration is that the reference setting value and the gate composite resistance Rt corresponding to it are stored in the nonvolatile memory in advance from the correlation data between the I1(r) value and the temperature rising value of the switching element obtained in a temperature test in advance, the reference setting value is set by the user from the digital operation panel 7, thereby the gate composite resistance Rt corresponding to the setting value is read out from the nonvolatile memory, and the serial resistance value RS corresponding to the gate composite resistance value is selected; or even if the configuration is that the reference setting value and the gate composite resistance Rt corresponding to it are stored in the nonvolatile memory in advance from the correlation data between the Ia value and the temperature rising value of the switching element, the reference setting value is set by the user from the digital operation panel 7, thereby the gate composite resistance Rt corresponding to the setting value is read out from the nonvolatile memory, and the serial resistance value RS corresponding to the gate composite resistance value is selected; or even if the configuration is that the reference setting value and the gate composite resistance Rt corresponding to it are stored in the nonvolatile memory in advance from the correlation data between the cosΦ value and the temperature rising value of the switching element, the reference setting value is set by the user from the digital operation panel 7, thereby the gate composite resistance Rt corresponding to the setting value is read out from the nonvolatile memory, and the serial resistance value RS corresponding to the gate composite resistance value is selected.

A power semiconductor switching element has tendency for their switching speed to slow even if the gate resistance value is the same, as current flowing through the elements increases, and the switching speed is faster and the noise level is higher when current flowing through the elements is smaller.

Consequently, being based on effective current or torque current or power factor enables appropriate determination of which state the motor is in, an overly excited state or a loaded state. Because determination speed is extremely fast, if detected effective current or torque current or power factor is small, increasing the gate drive resistance value of the gate drive circuits of the semiconductor switching element slows the switching speed, and thereby the noise level can be reduced.

As indicated in the above-described embodiments, in the power conversion device configured using a wide-bandgap semiconductor switching element with fast switching speed, controlling the speed of the wide-bandgap semiconductor switching element by changing the gate drive resistance value of gate drive circuits according to a load factor based on the torque current component or effective current component detected by the current detection circuit has advantages of being able to suppress leakage current due to dV/dt and to prevent induced malfunction of a flowmeter, a manometer or a variety of sensors that are situated in the vicinity of the power conversion device by noise due to dV/dt.

REFERENCE SIGNS LIST

1            Converter
2            Smoothing capacitor

| | |
|---|---|
| 3 | Inverter |
| 4 | Induction motor |
| 5 | Control circuit |
| 6 | Cooling fan |
| 7 | Digital operation panel |
| 8 | Gate drive circuit |
| 9 | Variable resistance circuit |
| 13 | Power conversion device |
| CT | Current detector |
| DIC | Drive IC |
| SH1, SHi, SHd | Shunt resistor for current detection at DC bus bar side |
| 8UP | Gate drive circuit in U-phase upper arm |
| 8UN | Gate drive circuit in U-phase lower arm |
| PWMUP | PWM signal for U-phase upper arm |
| PWMUN | PWM signal for U-phase lower arm |
| UPF | Signal for variable resistance circuit in U-phase upper arm |
| UNF | Signal for variable resistance circuit in U-phase lower arm |
| t | Time |
| * | Multiplication operator |
| EMC | Electro Magnetic Compatibility |

**Claims**

1. A power conversion device comprising:

   a converter for converting an AC voltage to a DC voltage;
   a DC intermediate circuit for smoothing the DC voltage converted by the converter;
   an inverter for converting the DC voltage smoothed by the DC intermediate circuit to an AC voltage;
   a gate drive circuit for driving a semiconductor switching element in the inverter;
   a current detector for detecting current flowing through the power conversion device; and
   a control circuit for detecting a current component value from the current detected by the current detector and for changing a gate resistance value of the gate drive circuit on the basis of the detected current component value or a power factor value obtained from the current component value.

2. The power conversion device according to claim 1, wherein
   the semiconductor switching element are wide-bandgap semiconductor elements.

3. The power conversion device according to claim 1, wherein
   the current detector detects current at an output side of the power conversion device or current at a DC bus bar side of the power conversion device.

4. The power conversion device according to claim 1, wherein
   the control circuit detects the detected current as a torque current component value or an excitation current component value by coordinate axis conversion, or detects an effective current component value or ineffective current component value by sampling a vicinity of a particular phase of the detected current.

5. The power conversion device according to claim 4, wherein
   the control circuit changes the gate resistance value of the gate drive circuit on the basis of the torque current component value or the effective current component value or the power factor value obtained from the current component value.

6. The power conversion device according to claim 5, wherein
   the control circuit makes the gate resistance value at an on-side or off-side of the gate drive circuit smaller than the value before change if the torque current component value or the effective current component value or the power factor value obtained from the current component value is larger than a preset value.

7. The power conversion device according to claim 5, wherein

the control circuit makes the gate resistance values at an on-side and an off-side of the gate drive circuit smaller than the values before change if the torque current component value or the effective current component value or the power factor value obtained from the current component value is larger than a preset value.

8.  A power conversion device control method comprising:

    a forward conversion step of converting an AC voltage to a DC voltage;
    a smoothing step of smoothing the DC voltage converted in the forward conversion step;
    an inverse conversion step of converting the DC voltage smoothed in the smoothing step to an AC voltage;
    a drive step of driving semiconductor switching element;
    a current detection step of detecting current flowing through the power conversion device; and
    a control step of detecting a current component value from the current detected in the current detection step and of changing a gate resistance value of a gate drive circuit on the basis of the detected current component value or a power factor value obtained from the current component value.

9.  The power conversion device control method according to claim 8, wherein
    the semiconductor switching element is wide-bandgap semiconductor elements.

10. The power conversion device control method according to claim 8, wherein
    the current detection step includes detecting current at an output side of the power conversion device or current at a DC bus bar side of the power conversion device.

11. The power conversion device control method according to claim 8, wherein
    the control step includes detecting the detected current as a torque current component value or an excitation current component value by coordinate axis conversion, or detecting an effective current component value or ineffective current component value by sampling a vicinity of a particular phase of the detected current.

12. The power conversion device control method according to claim 11, wherein
    the control step includes changing the gate resistance value of the gate drive circuit on the basis of the torque current component value or the effective current component value or the power factor value obtained from the current component value.

13. The power conversion device control method according to claim 12, wherein
    the control step includes making the gate resistance value at an on-side or off-side of the gate drive circuit smaller than the value before change if the torque current component value or the effective current component value or the power factor value obtained from the current component value is larger than a preset value.

14. The power conversion device control method according to claim 12, wherein
    the control step includes making the gate resistance values at an on-side and an off-side of the gate drive circuit smaller than the values before change if the torque current component value or the effective current component value or the power factor value obtained from the current component value is larger than a preset value.

## FIG.1

# FIG.2(a)

# FIG.2(b)

# FIG.2(c)

# FIG.3

# FIG.4

(a)

(b)

# FIG.5

# FIG.6

# FIG.7

# FIG.8

# FIG.9

(a)

(b)

# FIG.10

# FIG.11

Ra　　　La

Ia

v1

$Es=ke*\Phi m*f1$

MAGNET　　　MAGNET

$\Phi m$

# FIG.12

q AXIS

$Id=0$

$Iq=Ia$

$\Phi m$

d AXIS

(a)

q AXIS

$Id\neq0$

Ia

Iq

$\theta$

$\Phi d=\Phi m-k*Id$

$Id<0$

d AXIS

(b)

# FIG.13

SPEED
CONTROL

$fr^*$　+

$Iq^*$

Ks

$fs^*$

FREQUENCY
CONTROL

$fr$　−

f1

+
−

q-AXIS CURRENT
CONTROL

$Vq^*$

$Iq=Ia$

$Id^*$

+
−

d-AXIS CURRENT
CONTROL

$Vd^*$

Id

VECTOR COMPUTATION
CIRCUIT

$Vu^*$

$Vv^*$

$Vw^*$

PWM COMPUTATION
CIRCUIT

CT

CT

dq-AXIS
CONVERSION UNIT

CURRENT DETECTION
CIRCUIT

POSITION
SENSORLESS
CONTROL CIRCUIT

Ia

Iar

TORQUE CURRENT
COMPARISON CIRCUIT

GATE DRIVE CIRCUIT

23

# FIG.14

| TORQUE CURRENT REFERENCE SETTING VALUE (ABSOLUTE VALUE) $IA=Iq/Iqrr$ (%) | GATE COMPOSITE RESISTANCE $Rt$ ($\Omega$) |
|---|---|
| 0 | 100 |
| 10 | 90 |
| ⋮ | ⋮ |
| 70 | 50 |
| $70 < IA$ | 10 |

(a)

| TORQUE CURRENT REFERENCE SETTING VALUE (ABSOLUTE VALUE) $IA=Iq/Iqrr$ (%) | GATE COMPOSITE RESISTANCE $Rt$ ($\Omega$) |
|---|---|
| $0 < IA \leqq 50$ | 100 |
| $50 < IA \leqq 70$ | 50 |
| $70 < IA$ | 10 |

(b)

## INTERNATIONAL SEARCH REPORT

| International application No. |
| --- |
| PCT/JP2013/085030 |

**A. CLASSIFICATION OF SUBJECT MATTER**
*H02M7/537*(2006.01)i, *H02M1/08*(2006.01)i, *H02M7/48*(2007.01)i

According to International Patent Classification (IPC) or to both national classification and IPC

**B. FIELDS SEARCHED**

Minimum documentation searched (classification system followed by classification symbols)
H02M7/537, H02M1/08, H02M7/48

Documentation searched other than minimum documentation to the extent that such documents are included in the fields searched

| | | | |
| --- | --- | --- | --- |
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 3820167 B2 (Mitsubishi Electric Corp.), 13 September 2006 (13.09.2006), fig. 1, 4 to 6 (Family: none) | 1-14 |
| A | JP 2011-142752 A (Toshiba Corp.), 21 July 2011 (21.07.2011), paragraphs [0020], [0038], [0047], [0052], [0061]; fig. 1 to 3 (Family: none) | 1-14 |
| A | JP 2013-128356 A (Panasonic Corp.), 27 June 2013 (27.06.2013), paragraphs [0020] to [0027]; fig. 1 to 2 (Family: none) | 1-14 |

[×] Further documents are listed in the continuation of Box C.　　　[ ] See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 08 April, 2014 (08.04.14) | 22 April, 2014 (22.04.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/085030

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2012-228035 A  (Mitsubishi Electric Corp.), 15 November 2012 (15.11.2012), paragraphs [0025] to [0029], [0050] to [0053], [0092] to [0095]; fig. 1 to 2, 9 (Family: none) | 1-14 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3820167 B

- JP 4040960 B